# EUROPÄISCHE PATENTANMELDUNG

(11) **EP 4 213 185 A1**
(43) Veröffentlichungstag der Anmeldung: **19.07.2023**
(21) Anmeldenummer: 22151500.0
(22) Anmeldetag: 14.01.2022
(51) Int. Cl.: H01L 21/48, H01L 23/427, H01L 23/473

(54) **HYBRIDKÜHLKÖRPER**

(71) Anmelder: Siemens Aktiengesellschaft, 80333 München (DE)
(72) Erfinder: Knauer, Hans, 91359 Leutenbach (DE); Müller, Volker, 90459 Nürnberg (DE); Neugebauer, Stephan, 91058 Erlangen (DE); Schwarz, Florian, 90766 Fürth (DE)
(74) Vertreter: Siemens Patent Attorneys

(57) **Zusammenfassung**

Die Erfindung betrifft einen Hybridkühlkörper (1) mit zumindest einer Pulsierenden Heatpipe (7) und zumindest einer Flüssigkeitskühlung, die schichtartig übereinander angeordnet sind, wobei sich die Pulsierende Heatpipe (7) zwischen einer Wärmequelle und der Flüssigkeitskühlung befindet.

## Beschreibung

Die Erfindung betrifft einen Kühlkörper, ein mit einem derartigen Kühlkörper ausgestattetes Leistungsmodul und einen mit einem derartigen Kühlkörper ausgestatteten Stromrichter, des Weiteren ein Verfahren zur Herstellung eines derartigen Kühlkörpers.

Mit der fortschreitenden Miniaturisierung in der Mikroelektronik nimmt die Leistungsdichte von Elektronikmodulen und damit auch die Wärmestromdichte von den Elektronikmodulen erzeugter Wärme zu. Leistungsstarke elektrische Bauelemente wie Leistungshalbleiter erzeugen bereits heute thermische Verluste mit Wärmestromdichten von mehr als 100 W/cm², mit steigender Tendenz. Um Elektronikausfälle durch thermische Überlastungen zu vermeiden, werden daher immer effektivere Konzepte zum Entwärmen der elektrischen Bauelemente benötigt.

Ein idealer Kühlkörper hat eine homogene Temperaturverteilung über die gesamte Oberfläche. Hierdurch entsteht für die jeweilige Maximaltemperatur an jedem Punkt der Oberfläche ein maximaler Temperaturgradient normal zur Oberfläche, womit der Wärmestrom maximal ist. Um die Verlustwärme von Leistungshalbleitermodulen effektiv abzuführen, werden Wasserkühlkörper unterhalb der Leistungsmodule angebracht.

Bei einem Leistungsmodul beispielsweise eines Stromrichters bilden sich aufgrund der diskreten Energieeinbringung und einer begrenzten Wärmeverteilung des Leistungsmoduls und des Kühlkörpers hohe Temperaturgradienten mit Hot-Spots unter den Halbleiterchips, wobei vor allem Halbleiter in der Mitte des Moduls höhere Temperaturen erreichen.

Diesen Anforderungen wird heutzutage durch Anpassungen des Kühlkörpers Rechnung getragen, z.B. indem größere Kühlkörper und größere Fluidstromdichten eingesetzt werden oder dickere Bodenplatten von Modul oder Kühlkörper verwendet werden oder durch Einsatz von meist teueren Werkstoffen mit besserer spezifischer Wärmeleitfähigkeit.

Des Weiteren haben sich bereits seit Jahren für eine wirkungsvolle Kühlung von Leistungsmodulen Heatpipekühlkörper auf dem Markt durchgesetzt. Dabei verdampft durch den Wärmeeintrag einer Wärmequelle in einem geschlossenen Rohr des Heatpipekühlkörpers eine Flüssigkeit. Durch das Vakuum im geschlossenen Rohr kondensiert die Flüssigkeit an einer anderen Stelle des Rohres, von der die Wärme dann beispielsweise an die Umgebungsluft abgegeben werden kann. Zum Zurückfließen der Flüssigkeit im Rohr wird der Kapillareffekt genutzt. Dafür wird die Innenseite des Rohres mit einer kapillaren Struktur versehen.

US 2018/0158756 A1 offenbart eine integrierte Schaltungsvorrichtung mit mindestens einer auf einem Substrat angeordneten Halbleitervorrichtung, wobei das Substrat eine in ihm ausgebildete Pulsierende Heatpipe aufweist.

Nachteilig dabei ist weiterhin die unzureichende Kühleffizienz, insbesondere bei Geräten der Leistungselektronik.

Ausgehend davon liegt der Erfindung die Aufgabe zugrunde einen Kühlkörper bereitzustellen, der eine verbesserte Wärmeabfuhr aus einem Leistungsmodul oder einem Stromrichter gewährleistet, des Weiteren soll dieser Kühlkörper einfach herstellbar sein.

Die Lösung der gestellten Aufgabe gelingt durch einen HybridKühlkörper mit zumindest einer Pulsierenden Heatpipe und zumindest einer Flüssigkeitskühlung, die schichtartig übereinander angeordnet sind, wobei sich die Pulsierende Heatpipe zwischen einer Wärmequelle und der Flüssigkeitskühlung befindet.

Die Lösung der gestellten Aufgabe gelingt auch durch eine Leistungshalbleitereinheit mit
- einem erfindungsgemäßen Hybridkühlkörper,
- mindestens einem Leistungshalbleitermodul,
wobei das Leistungshalbleitermodul thermisch leitend mit dem Hybridkühlkörper derart verbunden ist, dass die durch Verlustleistung des Leistungshalbleitermoduls entstehende Wärme mittels der Pulsierenden Heatpipe flächig verteilt und über einen Flüssigkeits-, insbesondere einen Wasserkreislauf abführbar ist.

Die Lösung der gestellten Aufgabe gelingt auch durch einen Stromrichter mit einem erfindungsgemäßen Hybridkühlkörper oder einer erfindungsgemäßen Leistungshalbleitereinheit.

Die Lösung der gestellten Aufgabe gelingt durch ein Verfahren zur Herstellung eines erfindungsgemäßen Hybridkühlkörpers mit zumindest einer Pulsierende Heatpipe und einer Flüssigkeitskühlung, die schichtartig übereinander angeordnet sind, wobei sich die Pulsierende Heatpipe zwischen einer Wärmequelle und der Flüssigkeitskühlung befindet, durch folgende Schritte:
- Ausgestaltung von Kanälen der Flüssigkeitskühlung mit Ein- und Auslässen in einem thermisch leitenden Materialblock,
- Ausgestaltung von geschlossenen Kanälen für eine Pulsierende Heatpipe in einem Deckel,
- Einfüllen von Flüssigkeit in die Kanäle des Deckels zur Herstellung der Funktionsfähigkeit der Pulsierenden Heatpipe,
- Zusammensetzen des Materialblocks und des Deckels.

Dabei sind die Schritte des Herstellverfahrens nicht zwangsläufig in dieser Reihenfolge anzuwenden.

Eine Pulsierende Heatpipe (engl. pulsating heat pipe, PHP), die auch als oszillierende Heatpipe (engl. oscillating heat pipe, OHP) bezeichnet wird, ist eine Vorrichtung zur Wärmeübertragung mit einer geschlossenen oder offenen Kanalstruktur, in der ein Wärmetransportmedium angeordnet ist, das entlang der Kanalstruktur durch die dominierende Oberflächenspannung des Wärmetransportmediums abwechselnd Dampfsegmente und Flüssigsegmente bildet. Diese Dampf- und Flüssigsegmente werden durch einen Temperaturgradienten zum Pulsieren bzw. Oszillieren angeregt. An einer Wärmequelle dehnen sich die Dampfsegmente aufgrund der höheren Temperatur aus; zudem siedet flüssiges Wärmetransportmedium dort und nimmt dabei latente Wärme auf. An einer Wärmesenke schrumpfen die Dampfsegmente durch Kondensation gasförmigen Wärmetransportmediums und geben dabei latente Wärme ab. Die lokalen Temperatur- und Druckunterschiede treiben das ständige Pulsieren bzw. Oszillieren der Dampf- und Flüssigsegmente an.

Bei dem Betrieb dieser **P**ulsierenden **H**eat**p**ipe (PHP), wird nunmehr die kapillare Struktur einer klassischen Heatpipe nicht mehr benötigt. Auch bei der Pulsierenden Heatpipe erfolgt die Wärmeübertragung über ein Fluide, wobei Teile bzw. Abschnitte des Fluids gasförmig im Rohr oder einem Kanal vorhanden sind. Es liegen also entlang des Rohres bzw. Kanals abwechselnd Abschnitte unterschiedlicher Aggregatszustände vor, also Abschnitte mit Flüssigkeit und Abschnitte mit Gas. Aufgrund eines Wärmeeintrags beginnen sich die Abschnitte im Rohr bzw. Kanal hin- und her zu bewegen.

Für die Pulsierenden Heatpipes können nunmehr die erforderlichen Kanalstrukturen in einfacher Weise wie folgt bereitgestellt werden.

Zum einen über ein eigenes Rohrsystem, das vorzugsweise bereits vorab mit der Flüssigkeit bzw. einem Fluid gefüllt ist und in dementsprechende Materialen, vorzugsweise wärmeleitende Materialen eingebettet wird.

Andererseits lassen sich die Kanalstrukturen auch durch Einarbeiten von dementsprechenden Ausnehmungen in ein vorzugsweise wärmeleitendes Material herstellen. Diese Ausnehmungen werden abgedeckt und mit der erforderlichen Flüssigkeit gefüllt.

Die Innenseite des Rohres oder eines Kanals kann somit auch glatt ausgeführt sein, was die Herstellung vereinfacht.

Als Fluide bzw. Flüssigkeiten eignen sich insbesondere Wasser, Aceton oder Methanol oder andere Fluide bzw. Flüssigkeiten, die in einem Rohr oder Kanal mit einem Durchmesser < 3mm einsetzbar sind.

Erfindungsgemäß tritt durch die Pulsierenden Heatpipes eine Wärmespreizung, vorzugsweise im Wesentlichen flächige Wärmespreizung ein, die zusammen mit einer Flüssigkeitskühlung einen hocheffizienten Hybridkühlkörper schafft.

Die Wärmequelle, beispielsweise ein Leistungshalbleiter oder ein Stromrichter, weist einen oder mehrere Hot-spots auf, also eine ungleichmäßige Wärmeverteilung. Durch die an die Schicht mit den Pulsierenden Heatpipes ungleichmäßig abgegebene Wärme tritt nunmehr in dieser Schicht aufgrund der Pulsierenden Heatpipe eine Wärmespreizung und Vergleichmäßigung der Wärme auf. Dadurch kann die Flüssigkeitskühlung diese Wärme vergleichsweise gut aufnehmen und effizient abführen.

Durch diese vorhandene Wärmespreizung wird eine exakte Positionierung der Flüssigkeitskühlkanäle innerhalb des Hybridkühlkörpers weniger relevant. Dadurch müssen diese Flüssigkeitskühlkanäle nicht mehr zwingend direkt unter den Hot-spots verlaufen, sondern können in die u.a. für die Montierbarkeit geeignetere Bereiche innerhalb des Hybridkühlkörpers verschoben oder gar eingespart werden.

Durch die Pulsierende Heatpipe (PHP) kann nunmehr kostengünstig ein Hybridkühlkörper bereitgestellt werden, der einen vergleichsweise hohen Kühleffekt aufweist.

Ausnehmungen - also die späteren Kanäle der Flüssigkeitskühlung - werden in einen Materialblock vorzugsweise spanabhebend eingearbeitet, insbesondere gefräst. Mittels eines Vakuumlöt- oder Schweißprozesses wird ein Deckel auf die Bodenplatte aufgesetzt, der die gefrästen Ausnehmungen der Flüssigkeitskühlung verschließt. Es sind lediglich Ein- und Auslässe für die Flüssigkeitskühlung vorgesehen. Die Ausnehmungen verlaufen in der Grenzfläche bzw. Oberfläche des Materialblocks, um mit einem Deckel einfach abgedeckt werden zu können.

In einer Ausgestaltung verlaufen die Strömungsrichtungen von Flüssigkeitskühlung und der Pulsierenden Heatpipe quer, insbesondere senkrecht zueinander. Dies verbessert den Wärmeübergang und damit die Wärmeabfuhr.

Die Integration einer Pulsierenden Heatpipe in die erste Schicht des Hybridkühlkörpers erhöht die Wärmeleitfähigkeit um ein Vielfaches und verbessert damit deutlich die thermische Effizienz. Damit kann insbesondere bei vergleichsweise besserer Kühlleistung auf teurere Materialien, wie Kupfer, verzichtet werden. Generell sind aber alle strukturell hinreichend stabilen (und umformbaren) Materialien denkbar, so z.B. auch elektrisch isolierende oder extrem korrosionsresistente oder verschleißunempfindliche Materialien.

Vorzugsweise ist der Deckel und/oder Materialblock der Flüssigkeitskühlung aus Aluminium oder aus einem wärmeleitenden Kunststoff. Diese sind am Markt verfügbar, kostengünstig herstellbar und weisen eine hinreichend gute Wärmeleitfähigkeit auf.

Die Strukturen der einen oder mehreren Pulsierenden Heatpipes innerhalb des Deckels verlaufen in einer Art Schlangenform, Mäanderform oder U-Form, wobei hier die sich einstellenden Abstände zwischen den Biegungen einstellbar sind, um damit auch in Bereichen ev. Hot-spots der Leistungshalbleiter oder Stromrichter eine höhere Dichte der Pulsierenden Heatpipes zu erhalten.

Nicht nur die Kanalstrukturen von Flüssigkeitskühlung und/ oder der Pulsierenden Heatpipes können geprägt, gefräst, gebohrt, 3D-gedruckt, gespritzt und gegossen werden, insbesondere auch mit verlorener Form, sondern auch die Ansatzelemente für die Ein- und Auslässe in und aus den jeweiligen Kanalstrukturen.

Die Wärmequelle, beispielsweise ein Halbleiter, bei höheren Leistungen und damit einhergehenden Verlustleistungen, auch als Leistungshalbleiter bezeichnet, wird an der Bodenplatte befestigt. Diese Bodenplatte wird an einem Deckel, der die Pulsierenden Heatpipes beinhaltet oder abdeckt wärmeleitend befestigt. Der Deckel deckt die Ausnehmungen des Materialblocks ab und bildet damit die Kanäle der Flüssigkeitskühlung.

Dieser schichtartige Aufbau des Hybridkühlkörpers gewährleistet über die Wärmespreizung eine hohe Kühleffizienz.

Die Bodenplatte und der Deckel, als auch der Deckel mit dem Materialblock können beispielsweise mittels Lötens, Schweißen, Kleben, Klemmen, Verpressen oder einem anderen Verfahren dauerhaft miteinander verbunden werden.

Vergleichsweise hohe Wärmemengen können durch einen derartigen Hybridkühlkörper ohne nennenswerten Zeitverzug von der Wärmequelle wegtransportiert werden. Zudem kann der Hybridkühlkörper aus nur wenigen Teilen einfach, leistungsfähig und kostengünstig aufgebaut werden.

Der schichtartige Aufbau des Hybridkühlkörpers kann nicht nur in planaren Ebenen stattfinden, sondern die einzelnen Schichten können auch komplementär gebogen sein, um sich beispielsweise an gekrümmten Wärmequellen anzupassen.

Dabei werden die einzelnen Schichten zunächst geformt oder gebogen und werden anschließend - wie oben beschrieben - zu einem Hybridkühlkörper zusammengesetzt.

Weitere vorteilhafte Ausgestaltungen der Erfindung sind in den abhängigen Ansprüchen angegeben.

Die Erfindung sowie weitere vorteilhafte Ausgestaltungen der Erfindung werden anhand prinzipiell dargestellter Ausführungsbeispiele näher erläutert, darin zeigen:
- FIG 1: einen Schnitt durch einen Hybridkühlkörper,
- FIG 2: einen Schnitt durch einen weiteren Hybridkühlkörper,
- FIG 3: eine perspektivische Darstellung eines Hybridkühlkörpers,
- FIG 4: einen Stromrichter mit Leistungsmodulen.

Es sei angemerkt, dass unter dem Ausdruck "koaxiale Bauteile", bspw. koaxiale Komponenten, hier Bauteile verstanden werden, die gleiche Normalenvektoren aufweisen, für die also die von den koaxialen Bauteilen definierten Ebenen parallel zueinander sind. Des Weiteren soll der Ausdruck beinhalten, dass die Mittelpunkte koaxialer Bauteile auf der gleichen Rotations- bzw. Symmetrieachse liegen. Der Ausdruck verlangt nicht zwangsläufig, dass koaxiale Bauteile den gleichen Radius haben.

Der Begriff "komplementär" meint im Zusammenhang mit zwei Komponenten, welche "komplementär" zueinander sind, dass ihre äußeren Formen derart ausgestaltet sind, dass die eine Komponente vorzugsweise vollständig in der zu ihr komplementären Komponente angeordnet werden kann, so dass sich die innere Oberfläche der einen Komponente und die äußere Oberfläche der anderen Komponente idealerweise lückenlos bzw. vollflächig berühren. Konsequenterweise ist also im Falle von zwei zueinander komplementären Gegenständen die äußere Form des einen Gegenstandes durch die äußere Form des anderen Gegenstandes festgelegt. Der Begriff "komplementär" könnte durch den Begriff "invers" ersetzt werden.

Der Übersichtlichkeit wegen werden in den Figuren teilweise in den Fällen, in denen Bauteile mehrfach vorhanden sind, häufig nicht sämtliche dieser dargestellten Bauteile mit Bezugszeichen versehen.

Die im folgenden beschriebenen Ausführungen können beliebig kombiniert werden. Ebenso sind auch Einzelmerkmale der jeweiligen Ausführungen kombinierbar, ohne das Wesen der Erfindung zu verlassen.

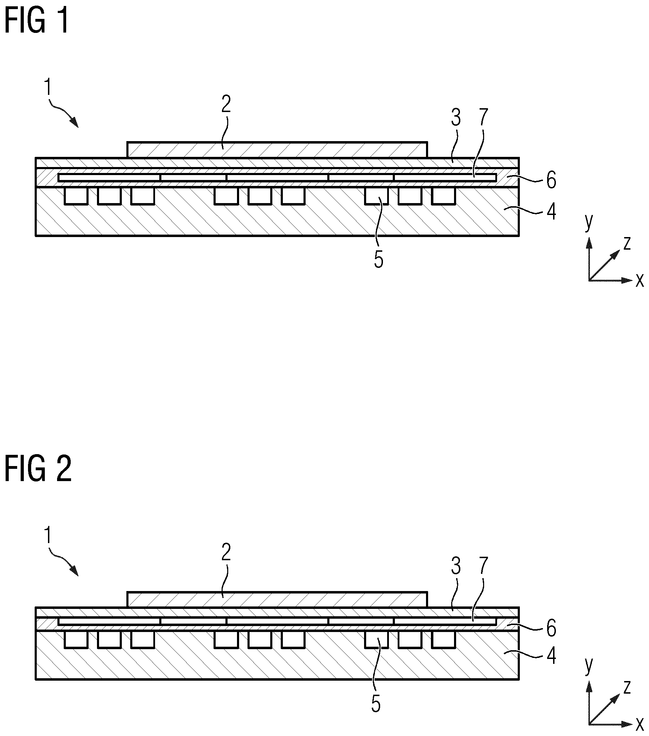

FIG 1 zeigt in einem Schnitt einen Hybridkühlkörper 1, der in einem beigefügten kartesischen Koordinatensystem (xyz) in y-Richtung schichtartig aufgebaut ist. Diese Schichtung stellt sich dabei wie folgt dar: Flüssigkeitskühlung 4, Deckel 6 der Flüssigkeitskühlung mit PHP 7. Darüber ist eine Bodenplatte 3 einer Wärmequelle, eines Elektronikmoduls oder eines Leistungsmoduls 2 thermisch angebunden. Dabei muss die Bodenplatte 3 nicht zwingend vollflächig ausgeführt sein.

Als Wärmequelle eines Leistungsmoduls 2 kommt grundsätzlich u.a. ein Leistungshalbleiter, z.B. ein MOSFET oder ein IGBT in Betracht.

Das Leistungsmodul 2 ist auf einer thermisch leitenden Bodenplatte 3 positioniert. Daran schließt sich ein Deckel 6 der Flüssigkeitskühlung mit einer integrierten Pulsierenden Heatpipe 7 an. Zur Ausgestaltung der Flüssigkeitskühlung sind dabei in einem thermisch leitenden Materialblock vorzugsweise nach oben (y-Richtung) offene Ausnehmungen eingearbeitet. Diese offenen Ausnehmungen werden durch den Deckel 6 abgeschlossen, wodurch sich Kanäle 5 der Flüssigkeitskühlung bilden. Die an der Oberfläche des Materialblocks bzw. Grenzschicht befindlichen Ausnehmungen lassen sich vergleichsweise einfach durch z.B. Fräsvorgänge aus dem Materialblock herausarbeiten. Der Materialblock, sowie die anderen an dem Wärmeleitvorgang beteiligten Komponenten, sind aus Aluminium oder dessen Legierungen oder Kupfer und dessen Legierungen oder anderen wärmeleitenden Materialen.

Gemäß dieser Ausführung ist der Deckel hohl ausgeführt und kann somit in dem Hohlraum eine oder mehrere jeweils abgeschlossene Pulsierende Heatpipes 7 aufnehmen, die beispielsweise aus z-Richtung eingeschoben wurden. Danach wird der Deckel abgedichtet.

FIG 2 zeigt in einer Ausführung einen zur FIG 1 identischen Kühlkörper 4, der aber zur Bodenplatte 3 hin mit einem zur y-Richtung offenen Deckel 6 abgeschlossen ist. Dieser Deckel 6 nimmt ebenfalls eine oder mehrere jeweils abgeschlossene Pulsierende Heatpipes 7 auf. Diese werden dabei aus y-Richtung in den Deckel 6 eingesetzt und mit einer Bodenplatte 3 des Leistungsmoduls 2 abgeschlossen.

Die Pulsierende Heatpipe 7 wird also direkt mit der Bodenplatte 3 des Leistungsmoduls 2 verschlossen. Dadurch werden weniger Bauteile für den Hybridkühlkörper 1 benötigt und der thermische Pfad von der Wärmequelle zur Flüssigkeitskühlung wird kürzer, was die Kühl-Effizienz nochmals steigert.

Die Pulsierende Heatpipe 7 ist also entweder als abgeschlossene Rohreinheit in komplementäre Ausnehmungen des Deckels 6 eingesetzt und/oder wird von Wärmeleitpaste umgeben, um eine Wärmespreizung sowohl nach FIG 1 als auch FIG 2 zu erhalten.

Es können aber genauso Kanäle bzw. Kapillare bzw. Kanalstrukturen in den Deckel 6 eingearbeitet, geätzt, gefräst etc. werden, um dann verschlossen und mit dementsprechender Flüssigkeit bzw. Fluiden gefüllt die Pulsierende Heatpipe 7 zu bilden.

Diese Kanäle bzw. Kapillare bzw. Kanalstrukturen der Pulsierenden Heatpipe sind vorzugsweise so dimensioniert, dass innerhalb des Kanals bzw. Kapillare bzw. Kanalstruktur kapillare Wirkungen erzielt werden, der Strömungswiderstand des Kanals bzw. Kapillare bzw. Kanalstrukturen jedoch begrenzt bleibt. Es ergeben sich, je nach eingefülltem Medium, üblicherweise Querschnittsdimensionen der Kanäle bzw. Kapillare bzw. Kanalstrukturen zwischen 0,5 mm und 8 mm, vorzugsweise zwischen 1,5 mm und 3 mm.

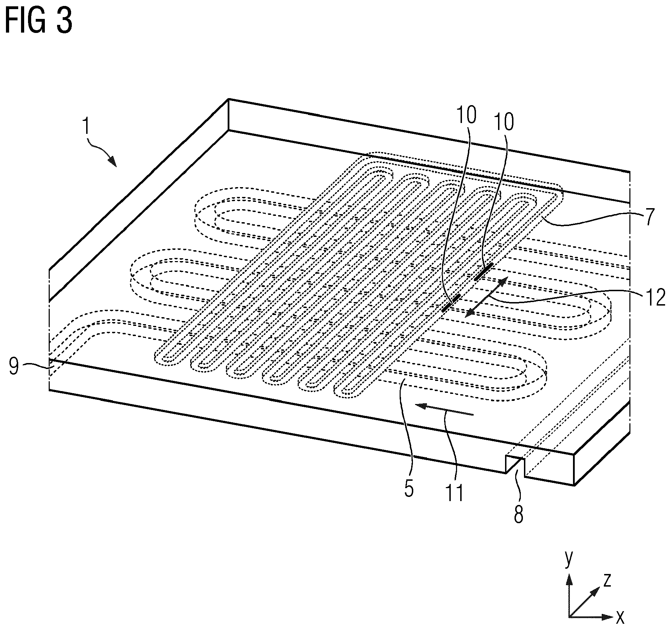

FIG 3 zeigt einen möglichen Aufbau eines erfindungsgemäßen Hybridkühlkörpers 1 mit einer integrierten pulsierenden Heatpipe 7 im Kühlkörper 4 einer Wasserkühlung. Im Wesentlichen quer zu den Wasserkühlkanälen 5 sind dabei Kanäle bzw. Kapillare bzw. Kanalstrukturen in den Kühlkörper 4 der Wasserkühlung eingearbeitet, z.B. gefräst. Nun wird ein weiterer Deckel oder eine Bodenplatte 3 für die Schicht des Hybridkühlkörpers 1 benötigt, der die Pulsierende Heatpipe 7 mit ausbildet.

Die Flüssigkeitskühlung als auch die Pulsierende Heatpipe 7 mäandern in der x-z-Ebene, wobei deren Hauptströmungsrichtung durch Pfeile 11, 12 dargestellt sind. Der Wärmetransport geschieht in y-Richtung, in der auch die Schichtung des Hybridkühlkörpers 1 stattfindet.

In einem Prozessschritt werden bei der Herstellung nun der gesamte schichtartige Verbund (Kühlkörper mit Wasserkanal, Deckel mit PHP und der Deckel der PHP) verschlossen.

Grundsätzlich wird nunmehr die an der Unterseite der Bodenplatte 3 anstehende Verlustwärme des Leistungsmoduls 2 durch die Pulsierende Heatpipe 7 flächig verteilt und kann somit von der Flüssigkeitskühlung besser aufgenommen und abgeführt werden. Diese Wärmespreizung der Pulsierenden Heatpipe 7 erhöht somit den Wärmetransport aus dem Leistungsmodul 2 zur Flüssigkeitskühlung.

Das pulsierende Flüssigkeits-Gas-Gemisch im Innern des Kanals der Pulsierenden Heatpipe 7 ist durch die Doppel-Pfeile 12 angedeutet. Die Strömungsrichtung der Flüssigkeit der Flüssigkeitskühlung mit Pfeilen 11 gekennzeichnet.

Zum Abschluss und ggf. Befüllen der Kanäle bzw. Kapillare bzw. Kanalstrukturen dienen nicht näher dargestellte Abschlussteile. Im Rahmen der Herstellung des Hybridkühlkörpers 1 wird die Pulsierende Heatpipe 7 an den Biegestellen in eine gewünschte Form, z.B. Mäanderform oder U-Form, gebracht.

Der mäanderförmige Teil der Pulsierenden Heatpipe 7 weist dabei Biegungen auf, die ca. einen Winkel von 180° aufweisen. Ebenso sind andere Biegeformen vorstellbar.

Der schichtartige Aufbau des Hybridkühlkörpers 1 kann nicht nur in planaren Ebenen stattfinden. Die einzelnen Schichten können auch komplementär gebogen sein, um sich beispielsweise an gekrümmten Wärmequellen anzupassen.

Dabei werden die einzelnen Schichten (also Kühlkörper 4 und Deckel mit Pulsierender Heatpipe 7) zunächst geformt oder gebogen und werden anschließend - wie oben beschrieben - zu einem Hybridkühlkörper 1 zusammengesetzt.

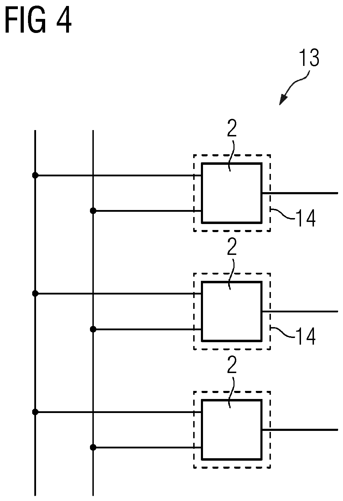

FIG 4 zeigt einen Stromrichter 13 mit drei Leistungshalbleitereinheiten 14. Die Leistungshalbleitereinheiten 14 weisen jeweils mindestens ein Leistungshalbleitermodul 2 auf. Das Leistungshalbleitermodul 2 wird mittels eines hier nicht näher dargestellten Hybridkühlkörpers 1 gekühlt bzw. entwärmt. Dabei ist der Hybridkühlkörper 1 gemäß einer der zuvor erläuterten Figuren ausgebildet.

## Patentansprüche

1. Hybridkühlkörper (1) mit zumindest einer Pulsierenden Heatpipe (7) und zumindest einer Flüssigkeitskühlung, die schichtartig übereinander angeordnet sind, wobei sich die Pulsierende Heatpipe (7) zwischen einer Wärmequelle und der Flüssigkeitskühlung befindet.

2. Hybridkühlkörper (1) nach Anspruch 1, **dadurch gekennzeichnet, dass** die Pulsierenden Heatpipe (7) im Deckel (6) der Flüssigkeitskühlung integriert ist.

3. Hybridkühlkörper (1) nach Anspruch 1 oder 2, **dadurch gekennzeichnet, dass** die Pulsierende Heatpipe (7) in einer Bodenplatte der Wärmequelle integriert ist.

4. Hybridkühlkörper (1) nach Anspruch 1, **dadurch gekennzeichnet, dass** die Pulsierende Heatpipe (7) zwischen einer Bodenplatte der Wärmequelle und einem Deckel der Flüssigkeitskühlung angeordnet ist.

5. Hybridkühlkörper (1) nach einem der vorhergehenden Ansprüche, **dadurch gekennzeichnet, dass** die Flüssigkeitskühlung als Wasserkühlung ausgebildet ist.

6. Hybridkühlkörper (1) nach einem der vorhergehenden Ansprüche, **dadurch gekennzeichnet, dass** die Schicht der Pulsierenden Heatpipe (7) und/oder die Schicht der Flüssigkeitskühlung eben flächige Schichten aufweist.

7. Hybridkühlkörper (1) nach einem der vorhergehenden Ansprüche, **dadurch gekennzeichnet, dass** die Schicht der Pulsierenden Heatpipe (7) und/oder die Schicht der Flüssigkeitskühlung gekrümmte Schichten aufweist.

8. Leistungshalbleitereinheit mit
- einem Hybridkühlkörper (1) nach einem der Ansprüche 1 bis 7 und
- mindestens einem Leistungshalbleitermodul (2),
wobei das Leistungshalbleitermodul (2) thermisch leitend mit dem Hybridkühlkörper (1) derart verbunden ist, dass die durch Verlustleistung des Leistungshalbleitermoduls (2) entstehende Wärme mittels der Pulsierenden Heatpipe (7) flächig verteilt und über einen Flüssigkeits-, insbesondere einen Wasserkreislauf abführbar ist.

9. Stromrichter mit einem Hybridkühlkörper (1) nach einem der Ansprüche 1 bis 7 oder einer Leistungshalbleitereinheit nach Anspruch 8.

10. Verfahren zur Herstellung eines Hybridkühlkörpers (1) mit zumindest einer Pulsierenden Heatpipe (7) und einer Flüssigkeitskühlung, die schichtartig übereinander angeordnet sind, wobei sich die Pulsierende Heatpipe (7) zwischen einer Wärmequelle und der Flüssigkeitskühlung befindet, durch folgende Schritte:
- Ausgestaltung von Kanälen der Flüssigkeitskühlung mit Ein- und Auslässen in einem thermisch leitenden Materialblock,
- Ausgestaltung von geschlossenen Kanälen für eine Pulsierende Heatpipe (7) in einem Deckel,
- Einfüllen von Flüssigkeit in die Kanäle des Deckels zur Herstellung der Funktionsfähigkeit der Pulsierenden Heatpipe (7),
- Zusammensetzen des Materialblocks und des Deckels (6).
